(19) **Europäisches Patentamt**

**European Patent Office**

**Office européen des brevets**

(11) **EP 1 152 861 B1**

(12) **EUROPÄISCHE PATENTSCHRIFT**

(45) Veröffentlichungstag und Bekanntmachung des Hinweises auf die Patenterteilung:
**29.03.2006  Patentblatt 2006/13**

(51) Int Cl.:
***B23K 1/20*** *(2006.01)*

(21) Anmeldenummer: **00902526.3**

(22) Anmeldetag: **14.02.2000**

(86) Internationale Anmeldenummer:
**PCT/CH2000/000082**

(87) Internationale Veröffentlichungsnummer:
**WO 2000/048779 (24.08.2000 Gazette 2000/34)**

(54) **VERFAHREN ZUR HERSTELLUNG VON BAUTEILEN, VERWENDUNG DESSELBEN, LUFTGELAGERTES WERKSTÜCK UND VAKUUMBEHANDLUNGSKAMMER**

METHOD FOR PRODUCING BUILDING COMPONENTS, USE THEREOF, AIRBEARING WORKPIECE AND VACUUM TREATMENT CHAMBER

PROCEDE DE FABRICATION D'ELEMENTS STRUCTURAUX, UTILISATION DESDITS ELEMENTS STRUCTURAUX, PIECE INSTALLEE SUR SUSPENSION PNEUMATIQUE ET CHAMBRE DE TRAITEMENT SOUS VIDE

(84) Benannte Vertragsstaaten:
**AT BE CH CY DE DK ES FI FR GB GR IE IT LI LU MC NL PT SE**

(30) Priorität: **19.02.1999   CH 31599**

(43) Veröffentlichungstag der Anmeldung:
**14.11.2001   Patentblatt 2001/46**

(73) Patentinhaber: **Unaxis Balzers Aktiengesellschaft 9496 Balzers (LI)**

(72) Erfinder:
• **RAMM, Jürgen**
  **CH-9475 Sevelen (CH)**

• **BECK, Eugen**
  **FL-9497 Triesenberg (LI)**

(74) Vertreter: **Troesch, Jacques J. et al Troesch Scheidegger Werner AG Postfach 8032 Zumikon (CH)**

(56) Entgegenhaltungen:
**EP-A- 0 427 020         EP-A- 0 677 737
US-A- 4 921 157**

## Beschreibung

Die vorliegende Erfindung betrifft ein Verfahren zur Herstellung von Bauteilen nach dem Oberbegriff von Anspruch 1, Verwendungen dieses Verfahrens nach den Ansprüchen 15 bis 16.

<u>Definitionen:</u>

Als innige Verbindungsverfahren werden Bonden (Schweissen, Löten), Kleben, Vergiessen sowie das Beschichten insbesondere in einem Vakuumbeschichtungsverfahren, sei dies PVD oder CDV oder davon abgeleitete Verfahren, verstanden, weiter sogenanntes "Direct Bonden", bei dem die Verbindung gut gereinigter Oberflächen direkt über interatomare Kräfte erfolgt, wie es z.B. beim direkten Waferbonden von Si auf Si, von Si auf $SiO_2$ eingesetzt wird, weiter beim Verbinden von Metalloberflächen unter sich oder von Metalloberflächen mit Si-Oberflächen, z.B. Cu-Si oder Au-Si. Bei diesen Verbindungen ist immer mindestens eine der innig zu verbindenden Oberflächen eine Festkörperoberfläche.

Im Rahmen der vorliegenden Erfindung sind insbesondere angesprochen:

- Metalloberflächen, dabei insbesondere aus Cu, Ni, Ag, Au, Pd, Pb, Sn, In oder aus Legierungen mit mindestens einem dieser Metalle,
- halbmetallische Oberflächen, insbesondere aus Si, Ge, B, C, GaAs, GaN, SiC, ZnO oder aus einem Material mit mindestens einem dieser Halbmetalle,
- Keramische Oberflächen, insbesondere aus Quarz, AluminiumOxyd, Aluminiumnitrid, Zirkonoxyd, Bornitrid, Diamant, Siliziumnitrid,
- Kunststoffoberflächen auf Epoxy- oder Esterbasis, Polyimide, Polyvinylchloride, Polyäthylen, Polystyrol, Polyolymethakrylat, Polyamid, Polyurethan, Phenoplaste, Phenolharze, Siloxane, Teflon,
- insbesondere Materialien, wie sie typischerweise bei Verpakkungsprozessen von Halbleitern ausgesetzt sind, nämlich gehärtete Epoxidharze (hardened epoxy resin), HLST-Materialien (Halbleiter-System-Träger) aus Epoxy (epoxy base laminate substrates), Lötstopplack, Photolack etc.

Wesentlich ist dabei, dass solche Oberflächen, welche der innigen Verbindung zu unterziehen sind, abschnittsweise unterschiedlich aus den verschiedenen genannten Materialien bestehen können. Die Energiezufuhr für das innige Verbinden ist in den meisten Fällen thermischer Art und wird zum Beispiel mittels beheizter Werkzeuge, joul'scher Wärme, UV-Strahlung oder vorzugsweise durch Ultraschall den zu verbindenden Oberflächen zugeführt oder aber durch Reaktionsenergie beim Kleben und ggf. auch beim Vergiessen.

Die vorliegende Erfindung wird insbesondere vorteilhafterweise beim Verpacken von integrierten Schaltungen eingesetzt. In diesem Sinne wird ihr Hauptanwendungsbereich auf dem Gebiet der Halbleiterindustrie gesehen. Allerdings kann die vorliegende Erfindung auch auf anderen Technologiebereichen eingesetzt werden, grundsätzlich in allen, bei denen im Rahmen des erfindungsgemässen Herstellungsverfahrens vor der Erstellung einer innigen Verbindung organische oder organisch/oxidische Kontaminationsverbindungen von der mindestens einen Festkörperoberfläche entfernt werden müssen.

Obwohl oben Oberflächenmaterialien definiert wurden, für die sich die vorliegende Erfindung erkanntermassen eignet, ist zu bemerken, dass auch andere Materialoberflächen, wie z.B. Oxide, Nitride, Carbide, Oxinitride, Oxicarbide, Carbonitride, Oxicarbonitride mindestens eines der Metalle Ti, Ta, Zr, Hr erfindungsgemäss behandelt werden können, wenn man insbesondere das innige Verbinden durch Beschichten berücksichtigt.

Wie erwähnt, eignet sich das erfindungsgemässe Vorgehen insbesondere auch für Festkörperoberflächen, welche aus verschiedenartigen Materialien bestehen, insbesondere Bereiche, die unterschiedliche Materialien aufweisen. Bezüglich der innigen Verbindbarkeit stellen solche Mehrmaterial-Oberflächen besonders schwierige Probleme.

Beim sogenannten Verpacken von integrierten Schaltungen, als ein bevorzugtes Einsatzgebiet der vorliegenden Erfindung, werden mehrere Arbeitsgänge unterschieden, welche ein inniges Verbinden von Oberflächen im obgenannten Sinne umfassen:

1. Die einzelnen integrierten Schaltkreise werden aus einem Siliziumwafer herausgeschnitten, auf Halbleiter-Systemträger (HLST) aufgebracht und mit diesen verbunden (sogenanntes "dye-bonding"). Die zu verbindende HLST-Oberfläche ist üblicherweise aus Kupfer oder Nickel, Silber oder Gold und/oder aus einem Material auf Epoxybasis, generell aus einem Kunststoff, wie oben erwähnt. Beispiele solcher HLST sind gestanzte oder geätzte metallische lead frames, keramische Substrate oder BGA (ball grid arrays)-Substratträger aus Kunststoff oder auch Leiterplatten PCB (printed circuit boards). Als Verbindungsverfahren werden Hartlöten, Weichlöten und Kleben eingesetzt. Bei Flip Chip Solder-Prozessen wird die integrierte Schaltung auf einem HLST mittels geometrisch getrennter solder balls aufgebracht, welche gleichzeitig als I/O-Kontaktierung benutzt werden.

2. Verbinden der integrierten Schaltkreise mit Kontaktstützpunkten am HLST, wie z.B. am "lead frame": Die beteiligten Oberflächen sind metallisch, wie aus Al, Au, Cu, Ni, Pd, Ag, Pb, Sn oder Legierungen dieser Metalle. Hier werden als Verbindungstechniken vornehmlich Löten oder Schweissen, dabei insbesondere flussmittelfreies Löten oder Ultraschallschweissen, eingesetzt. Dieser Schritt ist als "wire bonding" (Draht-Bonden) bekannt.

3. Vergiessen ("moulding"): Bei diesem Verfahrensschritt werden die Schaltkreise auf den HLST, z.B. den lead frames, nach dem "wire bonding" mit einer Vergussmasse vergossen, wobei bezüglich Vergussmasse die obgenannten Oberflächen von HLST und integrierten Schaltkreisen beteiligt sind.

Aus der EP-0 371 693 ist ein Reinigungsverfahren bekannt im Rahmen eines Herstellungsverfahrens, bei dem die nachmals im obgenannten Sinne allein durch Zuführung von Energie zu verbindenden Oberflächen erst einer Mikrowellen-Plasmaentladung in einer Wasserstoff enthaltenden Vakuumatmosphäre ausgesetzt werden. Darnach wird ohne Vakuumunterbruch mittels der Plasmaentladung die vorgesehene Lötschicht zum Verbinden der Oberflächen aufgeschmolzen. Somit wird eine verunreinigende Oberflächenbelegung, welche den anschliessenden Verbindungsprozess empfindlich stören würde, nur durch Vermeidung von Luftkontakt verhindert.

Aus der US 5 409 543 ist es weiter bekannt, aktivierten Wasserstoff zur Vorbereitung eines Lötvorganges einzusetzen. Dadurch wird eine Oxidschicht aufgeschlossen für den Durchgriff des Lötvorganges auf die Metalloberfläche.

Aus der EP-A-0 427 0 20 ist es weiter bekannt, eine Passiv- und Oxidschicht von Fügepartnern mittels einer Hochfrequenzplasma-Vorbehandlung mit einem Prozessgas zu dekapieren, d.h. aufzuschliessen. Als Prozessgase werden Gase bzw. Gasmischungen unter anderen aus $O_2$, $H_2$, $Cl_2$, $N_2O$, $N_2$, $CF_4$ etc. eingesetzt. Erfolgt dabei das erwähnte Dekappieren nicht wie bei der US-A-5 409 543 unmittelbar vor dem Lötvorgang, so werden die Fügepartner in Schutz-Zwischenspeichern gelagert, wozu, zur Verhinderung einer Kontamination, geeignete Behälter unter Schutzgas vorgesehen werden.

Im Rahmen der drei obgenannten Verpackungsschritte haben sich mittlerweile zwei Plasmabehandlungsschritte eingeführt. Dies vor allem für Substratträgermaterialien aus Kunststoff ("plastic ball grid arrays - PBGA"). Die Plasmabehandlung vor dem "wire bonding" (Schritt 2) dient dazu, die Oberflächen der metallischen Kontaktstützpunkte ("contact pads"), üblicherweise aus Aluminium, auf dem Dye (dem Chip) und die üblicherweise aus Gold bestehenden Kontaktstützpunkte auf dem Systemträger (HLST) zu reinigen, damit der elektrische Kontakt zum Verbindungsdraht, üblicherweise Golddraht, gewährleistet ist. Die wichtigste Quelle der Verschmutzung dieser Kontaktstützpunkte ist ein vorgelagerter Behandlungsprozess ("curing") der zum Aushärten eines im obgenannte Schritt 1 eingesetzten Epoxyklebers eingesetzt wird.

Eine zweite Plasmabehandlung erfolgt meist erst nach dem "wire bonding" (Schritt 2), vor dem "moulding" Prozessschritt (Schritt 3). Diese zielt darauf ab, eine verbesserte Vergussadhäsion zu erzielen.

Beide erwähnten Plasmabehandlungsschritte erfolgten üblicherweise in Vakuum, unter Plasma-Gasanregung. Dabei wird meist ein Hochfrequenz-, Mikrowellen- oder ECR-Plasma eingesetzt. Die Plasmaoberflächen-Wechselwirkung und der damit verbundene Reinigungsvorgang oder die Oberflächenmodifikation erfolgt über Sputtern und/oder eine chemische Reaktion mit plasmaangeregten Gasen. Für das Sputtern in nicht reaktiver Atmosphäre wird meist lediglich Argon eingesetzt und das Self bias-Potential des floatend betriebenen zu reinigenden Substrates ausgenutzt, um Argonionen zu letzterem hin zu beschleunigen und den erwünschten reinigenden Materialabtrag zu erzielen. Beim plasmachemischen Abtragen werden Reaktivgase, z.B. Sauerstoff, angeregt, dissoziiert oder ionisiert, die dann eine Reaktion mit Oberflächenverunreinigungen, z.B. Kohlenstoff eingehen und die gasförmigen Reaktionsprodukte, wie $CO_2$, über das Pumpsystem abführen.

Aus der WO97/39472 (EP 0 894 332) derselben Anmelderin wie vorliegendenfalls ist, u.a. zum Einsatz wie die vorerwähnten Plasmabehandlungsverfahren, ein höchst vorteilhaftes Behandlungs-verfahren bekannt geworden. Bei diesem prozess wird bevorzugterweise in einer Plasmaentladung Wasserstoff angeregt, der dann sowohl Kohlenstoff von Oberflächen entfernt (z.B. über $CH_4$), gleichzeitig aber auch Oxide an den beteiligten Oberflächen reduziert, zu $H_2O$-Gas. Dabei wird Sputtern vermieden, welches mit der Gefahr der Redeposition einhergeht, und der erwähnte Prozess kann uneingeschränkt auch auf metallische Substratträgermaterialien oder Silberkontaktflächen angewendet werden, die in einer Atmosphäre mit angeregtem Sauerstoff, insbesondere in einem sauerstoffhaltigen Plasma, stark oxidieren würden. Dies würde zu einer Beeinträchtigung der "wire bondability" oder "mouldability" (siehe oben, Schritt 2 und 3) führen. Dies ist weiter besonders wichtig, falls man Anwendungen für die moderne Kupfermetallisierung von Chips ins Auge fasst. Eine ganz wesentliche Eigenschaft des erwähnten Prozesses ist weiter diejenige, dass über das Wasserstoffplasma die Oberflächen für eine technologisch ausreichende Zeit passiviert werden und so vor Eingehen einer innigen Verbindung im obgenannten Sinne an Luft gelagert werden können.

Nachteilig am genannten Prozess ist, dass das Prozessfenster, d.h. der Bereich der jeweiligen Prozessparameter, weiterhin, in gewissem Umfang, vom Material der zu behandelnden, nachmals innig zu verbindenden Oberflächen abhängt. So erfolgt beispielsweise die Plasmabehandlung der Substratträgermaterialien (strips) normalerweise in Magazinen. Diese Magazine weisen Schlitze auf, damit die im Plasma angeregten Gase bis zu den behandelnden Substratoberflächen in das Magazin eindringen können und die flüchtigen Reaktionsprodukte der Reinigung leicht aus dem Magazin gelangen und abgepumpt werden können. Dabei bestehen die Substratoberflächen, insbesondere bei den PBGA ("plastic ball grid arrays") strips, immer aus einer Vielzahl unterschiedlicher Materialien. Der "solder resist" ist dabei eine langkettige organische Verbindung, die Oberfläche des "Die" (Chips) besteht beispielsweise aus Polyimid oder Siliziumnitrid, die Metallisierungspartie meist aus Aluminium und Gold. Dabei ist nie auszuschliessen, dass sich weitere organische Verunreinigungen auf der Oberfläche des "solder resists" aufhalten, die von vorgelagerten Prozessen, z.B. Reinigungsschritten, am Streifen stammen, sich während des Aushärtens des Epoxies im "curing-Prozess" niederschlagen oder von gezielten Oberflächenbehandlungen am "solder resist" resultieren, Behandlungen, um beispielsweise die Benetzbarkeit mit der Vergussmasse (mould-Masse) zu fördern. Unter Umständen sind dabei leichtflüchtige Verbindungen vorhanden, die besonders zu Beginn der vorerwähnten Plasmabehandlung verdampfen. Dies führt insbesondere in den erwähnten Magazinen - generell in kleinen Räumen - zu lokal höheren Drucken, wobei es vorkommen kann, dass das chemische Gleichgewicht aufgrund dieser lokalen Druckverschiebungen so verschoben wird, dass der reaktive Wasserstoff im oben erwähnten Prozess Kohlenwasserstoffe nicht mehr entfernt, sondern dass er eine Polymerisation fördert. Die Folge von solchen Wiederbedeckungen kann äusserst vielfältig sein. So wird z.B. auf den Kontaktstützpunkten ("contact pads") die "wire bondability" bezüglich erzielter Abreisskraft ("pull strength") herabgesetzt, oder es sind viel längere Behandlungszeiten erforderlich, um die abgeschiedene Schicht bei optimiertem Druck und ggf. höherer Temperatur wieder zu entfernen. Aufgrund der erwähnten Materialvielfalt an der zu behandelnden Oberfläche kann aber beispielsweise eine verlängerte Behandlungszeit oder eine intensivere Plasmabehandlung zwar die einen Flächen, wie Metallflächen, besser behandeln, gleichzeitig aber andere, wie den "solder resist" oder die Passivierungsschicht, so verändern, dass sich die Haftung der nachmals aufzubringenden Vergussmasse ("mould"-Masse) verschlechtert (s. Diskussion zu Versuchen II).

Es ist Aufgabe der vorliegenden Erfindung, ein Verfahren zur Herstellung von Bauteilen eingangs genannter Art zu schaffen, bei welchem das Prozessfenster, insbesondere das Vorbehandlungs-Prozessfenster, insbesondere dessen Abhängigkeit von unterschiedlichen Oberflächenmaterialien, aber auch von Prozessparametern, insbesondere von den Parametern "Druck" und "Temperatur", verbreitert wird. Mit anderen Worten soll das erfindungsgemäss vorgeschlagene Verfahren unter erweiterten Parameterbereichen, wie Druckbereichen und/oder Temperaturbereichen, über die ganze erwähnte Materialvielfalt gleichermassen zufriedenstellende Resultate ergeben, was die Qualität der nachmals vorzusehenden innigen Verbindung anbelangt.

Aufgrund des erwähnten vergrösserten Prozessfensters soll auch eine verbesserte Homogenisierung der Behandlungs-Wirkungsverteilung auch an Multi-Material-Oberflächen gewährleistet sein.

Wie erwähnt sollen insbesondere die Ergebnisse auch für Substrate in Magazinen oder für Substrate mit engen Geometrien (Spalten, Löchern) sichergestellt werden. Da die plasmachemischen Reaktionen an den Substratoberflächen auch von der Substrattemperatur abhängen und es besonders bei der Plasmabehandlung in Magazinen und auf ausgedehnten Substraten zu grösseren Temperaturgradienten kommt, soll die erwähnte Prozessfenster-Vergrösserung auch die Uniformität fördern.

Damit soll eine gleichbleibende Oberflächen-Behandlung auch von Spalt-Oberflächen, von Loch-Oberflächen, von Nut-Oberflächen etc. an Substraten selber ermöglicht werden.

Im weiteren soll die Wiederbedeckung der behandelten Oberfläche durch Abscheiden bzw. Polymerisation verhindert werden, das Verfahren soll kostengünstig sein, und es sollen keine explosiven und/oder umweltschädlichen Gase eingesetzt werden. Anderseits sollen die Vorteile des letzterwähnten, bekannten Verfahrens gemäss der WO97/39472, insbesondere auch dessen Konservierungseigenschaften, beibehalten werden.

Diesbezüglich wird definiert:

- Passivierung bzw. passiviert: siehe Römpps Chemielexikon, Franksche Verlagshandlung, Stuttgart, Ausgabe 8, Seite 3005.
  Darunter wird eine gebundene Schutzbelegung der Festkörper-Oberfläche verstanden. Die saubere Festkörper-Oberfläche wird vor atmosphärischen Lufteinflüssen geschützt. Dies erfolgt z.B. durch Bildung einer Oxid- oder Nitridschicht. Eine solche Schicht muss für die Erstellung einer innigen Verbindung obgenannter Art erst durch eine eigens dafür aufzubringende Energie aufgeschlossen werden, beispielsweise durch Aufbringen höherer Temperaturen, als für den eigentlichen Verbindungsvorgang erforderlich, oder chemisch, z.B. durch Einsatz eines Flussmittels.

- Vom genannten Passivieren unterscheiden wir grundsätzlich das Konservieren, welches insbesondere keinen Schichtaufschluss durch zusätzliche Energie beim Verbinden erfordert. Diese Konservierung ist im Zusammenhang mit der Erfindung gemäss der WO97/39472 erkannt worden, wesbezüglich vollumfänglich auf diese Schrift verwiesen wird und diese als integrierter Bestandteil der vorliegenden Beschreibung erklärt wird.

Die Lösung des obgenannten Problemes ergibt sich durch das Verfahren eingangs erwähnter Art und realisiert nach dem Kennzeichen von Anspruch 1. Demnach wird die Vorbehandlung mittels plasmaaktiviertem Gas vorgenommen, welches Stickstoff enthält.

Im weiteren enthält in einer bevorzugten Ausführungsform des erfindungsgemässen Herstellverfahrens das plasmaaktivierte Gas auch Wasserstoff.

Obwohl es durchaus möglich ist, eine beliebige der vielen bekannten Plasma-Entladungsarten einzusetzen, zur Plasmaaktivation des erwähnten Gases, wird in einer weitaus bevorzugten Ausführungsform die erwähnte Plasmaentladung als Niederspannungsentladung erzeugt, bevorzugterweise mit einer thermionischen Kathode.

Im weiteren enthält das plasmaaktivierte Gas bevorzugterweise ein Arbeitsgas, dabei bevorzugt ein Edelgas, insbesondere Argon.

Auch wenn das erwähnte plasmaaktivierte Gas nebst Stickstoff andere Gaskomponenten umfasst, insbesondere Wasserstoff und/oder ein Arbeitsgas, umfasst es in bevorzugter Art und Weise überwiegend Stickstoff, es besteht gar, abgesehen vom ggf. vorgesehenen Arbeitsgas, aus Stickstoff.

Die innig zu verbindenden Festkörperoberflächen sind dabei metallisch und/oder halbmetallisch und/oder keramisch und/oder bestehen aus Kunststoff, insbesondere gemäss den einleitend erwähnten, jeweilig bevorzugten Materialien. Insbesondere bevorzugt handelt es sich bei den erwähnten Festkörperoberflächen um Oberflächen mit Bereichen unterschiedlicher Materialien, insbesondere der genannten Materialien.

Das innige Verbinden wird beim erfindungsgemässen Herstellungsverfahren bevorzugt durch Kleben, Löten, Schweissen, Vergiessen oder Beschichten, dabei insbesondere Vakuumbeschichten, vorgenommen oder durch das sogenannte "direkte Bonden".

Die erwähnte bevorzugt eingesetzte Niederspannungsentladung wird weiter bevorzugt mit einer Entladespannung ≤ 30 V und bevorzugt mit einem Entladestrom zwischen 10 A und 300 A, beide Grenzen eingeschlossen, betrieben, insbesondere bei 40 A bis 70 A.

In einer besonders bevorzugten Ausführungsform des erfindungsgemässen Verfahrens wird die mindestens eine nachmals innig zu verbindende Festkörperoberfläche nach der erwähnte Vorbehandlung und vor ihrer innigen Verbindung Luft ausgesetzt, für Tage bis hin zu Wochen.

Dadurch ist es möglich, die erwähnte Oberfläche nicht unmittelbar nach ihrer Vorbehandlung weiterzuverarbeiten und nicht zwingend am gleichen Ort: Es ergibt sich eine hohe Flexibilität bezüglich Rhythmus und Behandlungsort zur Realisation des erfindungsgemässen Verfahrens, ohne dass zusätzliche aufwendige Reinhaltevorkehrungen, wie Schutzgaslagerung, vorzusehen wären.

In einer besonders bevorzugten Ausführungsform des erfindungsgemässen Verfahrens wird mindestens die eine Festkörperphase während der Vorbehandlung in einer Halterung gelagert, welche bezüglich des Plasmaentladungsraumes verengte Durchgriffsbereiche auf die erwähnte Oberfläche definiert. Dabei wird in der überwiegenden Zahl der Fälle die mindestens eine Festkörperphase durch ein scheiben- oder plattenförmiges Substrat gebildet, und es wird die Halteanordnung mit mindestens einem Durchgriffschlitz ausgebildet.

Bevorzugterweise weist dabei die Halteanordnung mehrere der erwähnten Durchgriffschlitze auf und bildet ein eigentliches Magazin.

Eine bevorzugte Verwendung des erfindungsgemässen Verfahrens besteht im Verbinden integrierter Schaltkreise mit HLST oder im elektrischen Kontaktieren integrierter Schaltkreise durch "wire bonding", oder für das Umhüllen von mit HLST verbundenen, durch "wire bonding" kontaktierten elektrischen Schaltkreisen mit einer Gussmasse.

Eine weitere bevorzugte Verwendung ist für Flip-Chip-zu-verbindende und zu positionierende integrierte Schaltkreise. Zum einen können die Lötpunkte vom Oxid gereinigt und gleichzeitig passiviert werden, zum anderen wird nach der Plasmabehandlung eine bessere Benetzung des sogenannten "underfill" (eine mold-Masse, die das gap zwischen chip und chip-Träger ausfüllt, und die zum Auffangen mechanischer Beanspruchungen dient) erreicht.

Im weiteren wird das erfindungsgemässe Verfahren bevorzugt auch für Werkstücke der in Anspruch 15 spezifizierten Art eingesetzt. Es eignet sich das erfindungsgemässe Verfahren besonders auch für Chips mit Cu-Leiterbahnen, nach Anspruch 16.

Ein behandeltes und an Luft lagerbares Teil ist z.B. erkenntlich daran, dass die Oberfläche gegenüber einer unmittelbar erzeugten Oberfläche des Teiles eine erhöhte Stickstoffkonzentration aufweist, was beispielsweise durch "Fourier transform infrared spectroscopy" mit "attenuated total reflection", FTIS-ATR und/oder mit "nuclear reaction analysis", NRA oder mit "time-of-flight secondary ion mass spectrometry", TOF-SIMS nachweisbar ist. Aufgrund der erhöhten Stickstoffkonzentration, welche auf die erfindungsgemässe Vorbehandlung hinweist, ist es möglich, das erfindungsgemässe Teil nach Luftlagerung unmittelbar und ohne weitere Vorbehandlung im obgenannten Sinne einer innigen Verbindung zuzuführen. Dabei wird es möglich, in einer weiteren bevorzugten Ausführungsform des erfindungsgemässen Verfahrens, die innige Verbindung durch thermische Einwirkung an Luft zu erstellen, vorzugsweise bei einer Festkörpertemperatur von höchstens 150°C.

Zusammenfassend kann gesagt werden, dass die erfindungsgemäss erkannte und ausgenutzte Wirkung von Stickstoff, gerade auch bei Berücksichtigung der Lehrmeinung (s. J.L. Vossen et al. "Thin Film Processes", ACADEMIC PRESS, INC. 1978), wonach $N_2$-Plasmen Polymeroberflächen nicht entfernten, überrascht.

Die Erfindung wird anschliessend beispielsweise anhand von Figuren und Beispielen erläutert. In den Figuren zeigen:

Fig. 1    schematisch, den Aufbau einer Anlage, wie sie für die beschriebenen Versuche eingesetzt wurde,

Fig. 2    die Auger-Spektren von Cu-Oberflächen ("lead frames") für die Erstellung einer Weichlotverbindung,

Fig. 3    schematisch, die Definition der Zugbelastung bzw. Abreisskraft $F_p$ von "wire bond"-Verbindungsstellen,

Fig. 4    die Resultate von Zugbelastbarkeits-Versuchen ("pull strength"), ausgeführt, wie anhand von Fig. 3 gezeigt, mit Wasserstoff-Argon-Plasmabehandlung (a), Argonplas- mabehandlung (b), Behandlung in einem $Ar/N_2/H_2$-Plasma (c), Behandlung ein einem $Ar/N_2$-Plasma (d),

Fig. 5    anhand eines Zeit/Zugbelastbarkeitsdiagramms den Langzeiteffekt der erfindungsgemäss eingesetzten Plasmabehandlung bzw. die Zugbelastbarkeit erstellter inniger Verbindungen an erfindungsgemässen Werkstükken,

Fig. 6    in Analogie zur Darstellung von Fig. 4, Resultate weiterer Zugbelastbarkeits-Versuche,

Fig. 7    schematisch, im Querschnitt, Flächenbereiche an Substraten, welche sich ebenfalls für den Einsatz des erfindungsgemässen Verfahrens eignen.

Wie erwähnt wurde, wird am erfindungsgemässen Herstellverfahren die Plasmaentladung zur Anregung des Gases weitaus bevorzugt als Niederspannungsbogenentladung ausgebildet. Anlagen der bevorzugterweise eingesetzten Art sind bekannt, z.B. aus:

- DE-OS 43 10 941, entsprechend der US-5 384 018

- DE-40 29 270, entsprechend der EP-478 909 bzw. der DE-40 29 268, entsprechend der US-5 336 326

- EP-510 340, entsprechend der US-5 308 950

Diese nur beispielsweise aufgeführten Schriften zeigen alle Behandlungskammern für Werkstücke unter Einsatz von Niederspannungsbogenentladungen. Bezüglich der Ausbildung solcher Behandlungskammern sollen diese Schriften integrierter Teil der vorliegenden Beschreibung bilden.

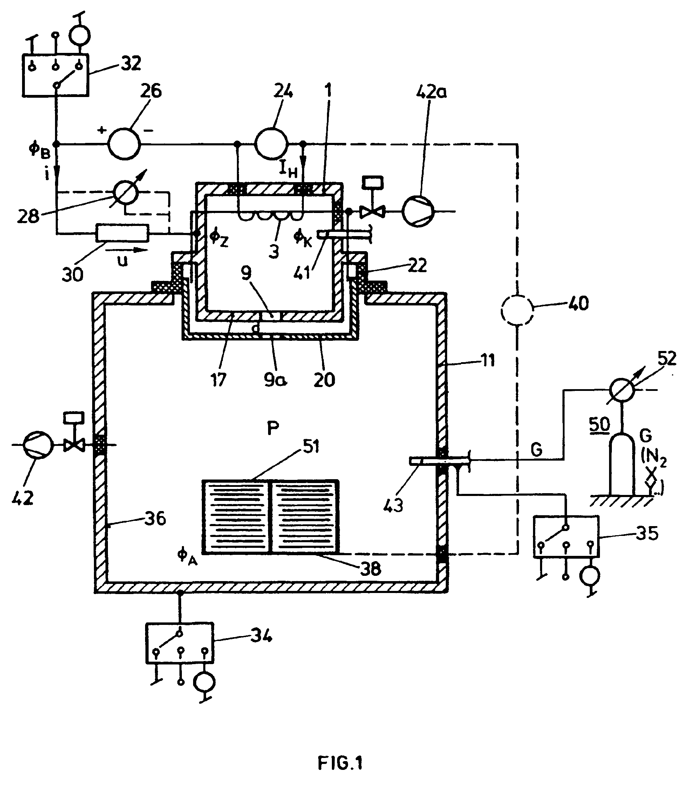

In Fig. 1 ist eine bevorzugte Anlage für den Einsatz gemäss vorliegender Erfindung dargestellt. In einer Kathodenkammer 1 ist eine thermionische Kathode 3 isoliert montiert. Partien 17 der Kathodenkammer 1 umranden eine Blendenöffnung 9. Die Kathodenkammer 1 ist über Isolationsträger 22 an der Wand der Behandlungskammer 11 montiert. Es umschliesst ein Schirm 20, der sowohl bezüglich Kathodenkammer 1 wie auch bezüglich Behandlungskammer 11 potentialschwebend betrieben wird, die Partien 17 auf Dunkelraumabstand d bis unmittelbar in den Bereich der Blendenöffnung 9. Die thermionische Kathode wird mittels einer Quelle 24 mit dem Heizstrom $I_H$ betrieben und ist über eine Spannungsquelle 26 und, generell gesprochen, eine Einheit 28 auf mindestens einen Teil der Kathodenkammerwand geführt, bevorzugterweise auf die Kathodenkammerwand selbst. Die Einheit 28 wirkt als Strombegrenzung und bewirkt in Funktion des sie durchfliessenden Stromes i einen Spannungsabfall u. Sie kann, wie gestrichelt dargestellt, durch eine stromgesteuerte Spannungsquelle realisiert sein, wird aber bevorzugterweise durch ein passives Schaltelement, dabei insbesondere durch ein Widerstandselement 30, realisiert.

Der positive Pol der Spannungsquelle 26 kann auf ein Bezugspotential, sei dies Masse, oder ein weiteres vorgegebenes Potential gelegt werden oder kann potentialfrei betrieben werden, wie dies rein schematisch durch den Möglichkeitsumschalter 32 dargestellt ist. Desgleichen kann, da von der Kathodenkammer 1 elektrisch isoliert, die Behandlungskammer 11, wie mit dem Möglichkeitsumschalter 34 rein schematisch dargestellt, auf Massepotential, auf einem Bezugspotential oder gegebenenfalls sogar potentialschwebend betrieben werden. Die Behandlungskammer-Innenwand 36 oder mindestens Partien davon können bezüglich der thermionischen Kathode 3 als Anode geschaltet sein; bevorzugterweise wird aber eine separate Anode 38, wie gestrichelt dargestellt, vorgesehen, welche über eine Spannungsquelle 40 mit Bezug auf die thermionische Kathode 3 anodisch, d.h. positiv, beschaltet wird. Die Anode 38 wird dabei bevorzugterweise als Werkstückträger für die schematisch eingetragenen Werkstücke W verwendet. Der Kathodenkammer wird über Gaszuspeiseleitung 41 ein Arbeitsgas, beispielsweise und vorzugsweise Argon, zugeführt. Ueber eine weitere, schematisch dargestellte Gaszuspeiseleitung 43, wie mit dem Möglichkeitsschalter 35 schematisch dargestellt, je nach Potentiallegung der Kammer 11 auf Potential legbar, wird das stickstoffenthaltende Gas G(X, Y, N$_2$), vorzugsweise Stickstoff, von einer Gastankanordnung 50, zugeführt. Das Gas G wird über ein schematisch dargestelltes Ventil 52 eingelassen.

Als Werkstückträger 51 wird, insbesondere bei industriellem Einsatz des erfindungsgemässen Verfahrens, mit der schematisch in Fig. 1 dargestellten erfindungsgemässen Behandlungskammer ein Magazin 51 eingesetzt. Darin sind eine Mehrzahl zu behandelnder Substrate gestapelt und nur über front- und/oder rückseitige Einlegeschlitze für die Substrate sowie zusätzlich in die Magazinwand eingearbeitete Durchgriffschlitze 51a mit dem Prozessraum P in der Kammer verbunden. Die geometrischen Verhältnisse H bezüglich der verbleibenden Kommunikationsöffnungen (Durchgriffsschlitze) zwischen den Substratoberflächen und dem Prozessraum P können dabei wesentlich geringer sein als der Dunkelraumabstand der in der Kammer unterhaltenen Plasmaentladung. Die erfindungsgemäss eingesetzte Oberflächenbehandlung ergibt sich durch das durch die Entladung angeregte Stickstoff-haltige Gas, welches durch die erwähnten Öffnungen bzw. Schlitze ins Magazin eintritt.

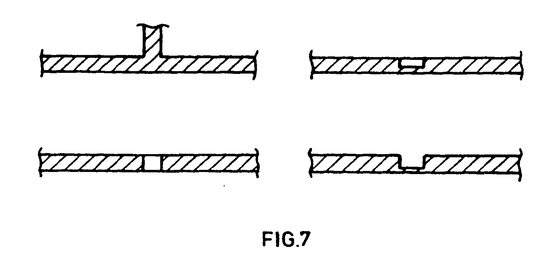

Bereits hier ist ersichtlich, dass das erfindungsgemäss eingesetzte Behandlungsverfahren sich mithin auch eignet, an Werkstücken bzw. Substraten schlecht zugängliche Oberflächenbereiche zu reinigen, wie an Kanten, an Bohrungen, Sacklöchern, Nuten etc., welche Oberflächenbereiche nachmals einer innigen Verbindung zuzuführen sind. Schematisch sind solche Oberflächenbereiche in Fig. 7 dargestellt.

Eine Pumpanordnung 42 ist vorgesehen, um die Kammer 11 und gegebenenfalls die Kathodenkammer 1 abzupumpen, wobei, wie dargestellt, zusätzlich eine Pumpanordnung 42a vorgesehen sein kann, um die Kathodenkammer getrennt abzupumpen. Die Blendenanordnung mit der Blendenöffnung 9 wirkt als Druckstufe zwischen Druck in der Kathodenkammer 1 und Druck in der Behandlungskammer 11.

Es bildet die Wand der Kathodenkammer 1 Zündelektrode: Zum Zünden der Niederspannungsentladung wird die thermionische Kathode 3 zur Elektronenemission mit dem Heizstrom $I_H$ aufgeheizt, und es wird Argon in die Kathodenkammer eingelassen. Auf Grund der Abstandsrelation zwischen Wand der Kathodenkammer 1 und der Kathode 3 erfolgt durch Potentiallegung letzterer die Zündung der Entladung, worauf ein Strom i durch die Einheit 28, insbesondere den Widerstand 30, fliesst. Damit reduziert sich das vormals auf Zündwert liegende Potential $\Phi_Z$ der Kathodenkammerwand 17, womit im Betrieb die Wandung der Kammer 1 nur noch in vernachlässigbarem Masse als Anode wirkt und die Primärentladung durch die Blendenanordnung mit der Oeffnung 9 auf die behandlungskammerseitige Anode 38 gezogen wird.

Mit einer wie in Fig. 1 dargestellten Kammer wurden die Oberflächen zu verbindender Werkstücke behandelt. Es kann sich dabei z.B. um

- metallische lead frames für Weichlöten, beispielsweise aus Cu, vernickeltem Cu, silberplattiertem Cu,

- organische HLST-Materialien, wie BGA ("ball grid arrays") und MCM ("multi chip modules"), beispielsweise auf Epoxy-oder Esterbasis, sowie PCB ("printed circuit boards"),

- metallische QFP ("quad flat packs"), beispielsweise aus Cu, versilbertem Cu, Pd-plattiertem Cu,

- die Metallisierung der Leiterbahnen für die organischen HLST-Materialien und die QFP, beispielsweise aus versilbertem Cu, vergoldetem Cu, Au,

- Halbleitersubstratträger als Flip Chip ausgebildet mit Lötpunkten, beispielsweise aus AgSn, PbSn, PbSnAg, PbInAg,

- HLST-Materialien auf Keramikbasis, beispielsweise Aluminiumoxid,

- Oberflächenschutzschicht der Chips, beispielsweise aus Siliziumnitrid, Siliziumoxinitrid, Polyimid,

- direkt gebondete Si-Si-Wafers

handeln.

<u>Behandlungsbeschreibung</u>:

Die Behandlungskammer gemäss Fig. 1, welche für die zu beschreibenden Versuche verwendet wurde, hatte ein Volumen von

$$V \cong 150 \ 1$$

Die Werkstücke oben angegebener Art wurden in die Kammer eingeführt und letztere wie folgt betrieben:
1. Abpumpen auf Basisdruck von ca. $10^{-5}$mbar;
2. Aktivierung der Kathode 3 mit $I_H$ ca. 190A;
2.1 Argon/Wasserstoffplasma (Referenzversuch)

| | |
|---|---|
| Entladestrom: | • Versuche I: 50A |
| | • Versuche II: 60A |
| Argonfluss: | 20 sccm |
| Behandlungszeit: | • Versuche I: 10 min. |
| | • Versuche II: 10 bzw. 20 min. |

2.2 Vorbehandlung im Argonplasma (zweites Referenzbeispiel)

| | |
|---|---|
| Entladestrom: | • Versuche I: 50 A |
| | • Versuche II: 60 A |
| Argonfluss: | 20 sccm |
| Behandlungszeit: | • Versuche I: 10 min. |
| | • Versuche II: 10 bzw. 20 min. |

2.3 erfindunsgemässe Vorbehandlung (Komb . $N_2 + H_2$)

| | |
|---|---|
| Entladestrom: | • Versuche I: 50 A |
| | • Versuche II: 60 A |
| Argonfluss: | 20 sccm |
| Stickstoff- und Wasserstofffluss: | Total 20 sccm, 4 Vol.% $H_2$ |
| Behandlungszeit: | • Versuche I: 10 min. |
| | • Versuche II: 10 bzw. 20 min. |

2.4. erfindungsgemässe Vorbehandlung (nur $N_2$)

| | |
|---|---|
| Bogenstrom: | • Versuche I: 50 A |
| | • Versuche II: 60 A |
| Argonfluss: | 20 sccm |
| Stickstofffluss (rein): | 20 sccm |
| Behandlungszeit: | • Versuche I: 10 min. |
| | • Versuche II: 10 bzw. 20 min. |

In allen Fällen wurde nach ca. 30 sek. Aufheizzeit der thermionischen Kathode mit einem Heizstrom von ca. 190 A, Zündspannung zwischen Kathode 3 und Zündelektrode 17 (siehe Fig. 1) gelegt. Der Widerstand 30 wurde zu ca. 20 Ohm gewählt und auf Masse gelegt. Nach Zünden der Entladung (Zündspannung ca. 20 - 30 V) stellt sich eine Entladespannung zwischen Kathode 3 und Anode 38 von ca. 25 V bei 50 A Entladestrom ein, unter bevorzugter Verwendung eines Schweissgenerators, wenn die Rezipientenwandung 11, auf Masse, als Anode eingesetzt wird.
Es werden Ionen und angeregte Neutrale erzeugt, wofür das typische Plasmaleuchten Indiz ist. Die zu behandelnden Werkstücke in Magazinen wurden in dem so erzeugten Plasma oberflächenbehandelt. Die Stickstoff- und gegebenenfalls Wasserstoffflüchtigen Verbindungen mit Verunreinigungen wurden mit der Pumpanordnung 42 abgepumpt.
Der Arbeitsdruck betrug ca. $5 \times 10^{-3}$ mbar.
Wie in Fig. 1 dargestellt, wurden Magazine 51 mit Durchgriffschlitzbreiten H (s. Fig. 1) von 1 mm bis 10 mm verwendet.

Anstatt das Magazin und damit die Werktücke auf Massepotential zu legen, können insbesondere letztere auch potential-fliegend (floating) oder auf ein anderes Referenzpotential gelegt der Plasmabehandlung ausgesetzt werden. Dadurch, dass das Potential der Werkstücke bezüglich Plasmapotential in der beschriebenen Niederspannungsentladung sehr niedrig ist, $\leq /20/$ V, wird sowohl das Problem der Redeposition von Material auf den Werkstücken, zu der es beim sogenannten Freisputtern kommt, wie auch und insbesondere die Gefahr der Zerstörung von bezüglich elektrischen Potentialdifferenzen kritischen IC's ausgeschlossen. Die Reinigung und Konservierung erfolgt allein über chemische Prozesse, die entweder durch Elektronen, bei entsprechend potential gelegten Werkstücken, oder durch niederenergetische Ionen und Elektronen bei fliegend (floatend) betriebenen Werkstücken bewirkt wird.

Die grosse Zahl in das Plasma eingekoppelter Elektronen sichert eine hohe Reaktivität des Plasmas, damit kurze Behandlungszeiten, was massgeblich zur Wirtschaftlichkeit des vorgeschlagenen Verfahrens beiträgt. Ein weiterer Vorteil besteht darin, dass das Plasma in kleine Hohlräume eindringen kann, insbesondere in das dargestellte Magazin. Damit können z.B. Werkstücke ohne Entnahme aus den dargestellten Kassetten bzw. Magazinen behandelt werden, was besonders wirtschaftlich ist.

Es wurden als Werkstücke PBGA-HLST behandelt sowie "lead frames" mit Cu-Oberflächen für die nachmalige Erstellung einer Weichlotverbindung.

Resultate:

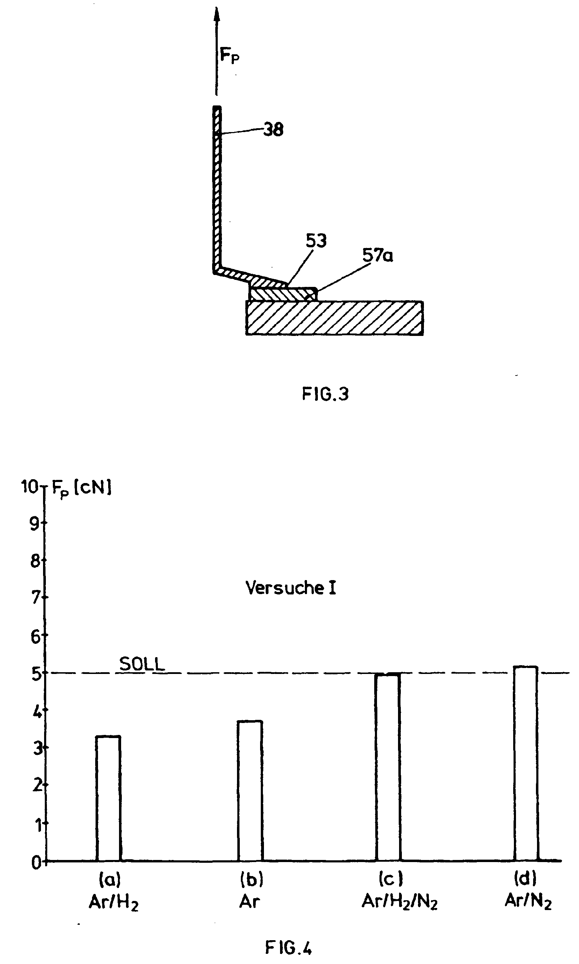

In Fig. 4 sind Zugbelastbarkeits-Resultate dargestellt. An den erfindungsgemäss behandelten PBGA-HLST wurde die Zubelastbarkeit bzw. Zugkraft $F_p$ der innigen Verbindungen gemessen, welche durch Golddraht-wire bonding erstellt wurde. In Fig. 3 ist dieses Vorgehen schematisch dargestellt. Darin bezeichnen 53 die Verbindungsstelle mit der erfindungsgemässe behandelten Oberfläche eines "lead frames" 57a.

Die Oberflächen der behandelten Substrate waren vorgängig von den Herstellern in nicht bekannter Art und Weise behandelt worden. Nach dieser Vorbehandlung war die Gefahr einer Redeposition aus der Gasphase, d.h. Plasmapolymerisation, an der Oberfläche absehbar.

An den nicht weiter behandelten Substraten, direkt von den Herstellern, konnten keine "wire bonding"-Verbindungen erstellt werden. Die resultierende Zugbelastbarkeiten sind in Fig. 4 für die Versuche I dargestellt. Dabei waren gerade die behandelten Substrate Substrate, welche für eine Argon/Wasserstoffplasma-Behandlung ungeeignet sind: Die befürchtete Redeposition aus der Gasphase, d.h. Plasmapolymerisation, trat bei Argon/Wasserstoffplasma-Behandlung tatsächlich ein, wie die relativ schlechten Zugbeanspruchbarkeits-Resultate (a) zeigen.

Es wurde dabei eine Zugbelastbarkeit von ca. 3,3 cN gemessen.

Bei Behandlung im Argonplasma ergaben sich (b) leicht verbesserte Resultate, mit Zugbelastbarkeiten von ca. 3,6 cN. Dabei führte offenbar allein das Erwärmen der Substratoberflächen und die damit verbundene Desorption schon zu besseren Werten, als man sie im Argon/Wasserstoffplasma aufgrund der Plasmapolymerisation erzielte.

Deutlich bessere Werte wurden als Resultat der erfindungsgemässen Behandlung gemessen, nämlich im Argon/Stickstoffplasma mit geringem Wasserstoffanteil, im vorliegenden Fall von ca. 4 % gemäss (c) und im Argon/Stickstoffplasma gemäss (d). An dieser Stelle sei bemerkt, dass, wenn dem anzuregenden Gas G Wasserstoff beigemischt wird, dies jedenfalls zu einem geringeren Anteil erfolgen soll, als das Gas Stickstoff enthält.

Bei den erfindungsgemäss behandelten Substraten wurden Zugbelastbarkeiten von ca. 5 cN (c) bzw. von weit über 5 cN gemessen (d) .

Grundsätzlich werden üblicherweise SOLL-Zugbelastbarkeiten an den beschriebenen Verbindungen von 5 cN verlangt.

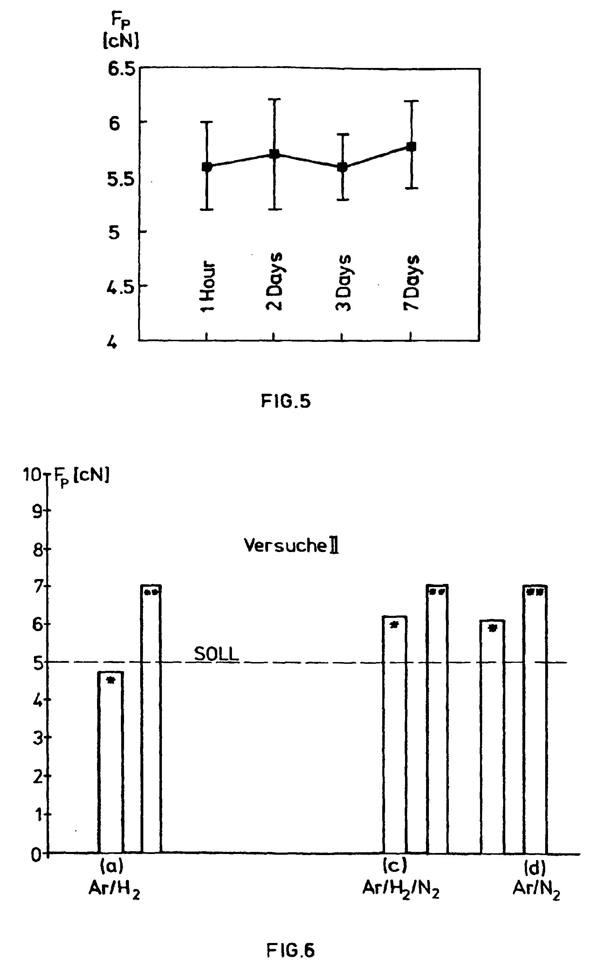

In Fig. 5 ist der Langzeiteffekt der Reinigungswirkung für Substrate dargestellt, welche, wie eben beschrieben wurde, nach Versuch I (c) behandelt wurden, d.h. in Argon/Stickstoff/Wasserstoff (4 Vol$_{N2}$%) -Plasmen.

Es ist einerseits die Zugbelastbarkeit $F_p$ abgetragen, anderseits die Lagerzeit der behandelten Substrate an Luft bis zur Erstellung des "wire bondings".

Es zeigt sich, dass die gemessenen Zugbelastbarkeits-Werte gar über sieben Tage innerhalb der Messgenauigkeit unverändert bleiben, d.h. dass es zu keiner Rekontamination der im erfindungsgemäss eingesetzten Plasmabehandlungsprozess freigelegten Oberflächen kam.

In Fig. 6 sind die Resultate der Versuche II in Analogie zu den Versuchen gemäss Fig. 4 dargestellt. Die mit "*" bezeichneten Resultate ergaben sich bei 10-minütiger Behandlung, diejenigen mit "**" bei 20-minütiger. Der Entladestrom betrug wie erwähnt 60 A. Es entsprechen sich die Versuche (a) bis (d) gemäss Fig. 6 und diejenigen gemäss Fig. 4. In Fig. 6 sind die Versuche an in Argonplasmen behandelten Substraten nicht dargestellt, welche aber deutlich schlechter waren als die Versuche gemäss (a), d.h. im Argon/Wasserstoffplasma.

Daraus ist ersichtlich, dass trotz höheren Entladestromes, verglichen mit den Versuchen I, bei 10-minütiger Behandlung in Argon/Wasserstoffplasma (a) immer noch die geforderten 5 cN Zugbelastbarkeiten nicht erreicht werden. Für die Plasmenbehandlungen gemäss (c) und (d) liegen sie aber bereits bei der erwähnten 10-minütigen Behandlung bei 60 A Bogenstrom weit über dem geforderten Wert, nämlich bei ca. 6,5 cN (c) bzw. bei 6 cN (d). Damit lassen sich im Argon/Wasserstoffplasma die ähnlich guten Resultate nur durch Verlängerung der Prozesszeit erreichen. Dies geht einher mit höherer thermischer Belastung der Substrate bzw. es können bei längerer Prozessdauer an Substraten mit anderen zusätzlichen Materialoberflächen unerwünschte Effekte auftreten. Während an Substraten, welche gemäss (c) bzw. (d) erfindungsgemäss behandelt worden waren, ein anschliessendes "molding" keinerlei Probleme bereitete, wurden an den gemäss (a) behandelten Substraten (Fig. 6) eine teilweise Delamination der "mold"-Masse beobachtet. Gerade dies zeigt, dass auch bezüglich Materialien, die zum Einsatz kommen, das erfindungsgemäss eingesetzte Behandlungsverfahren ein verbreitertes Prozessfenster aufweist.

Wesentlich ist noch zu bemerken, dass die anhand von Fig. 6 vorgestellten Zugbelastungsversuche an fünf Tage nach ihrer erfindungsgemässen Plasmabehandlung gebondeten Substraten vorgenommen wurden, wogegen die Versuche I gemäss Fig. 4 bei Bonden am gleichen Tage resultierten, an welchem auch die Plasmabehandlungen vorgenommen wurden.

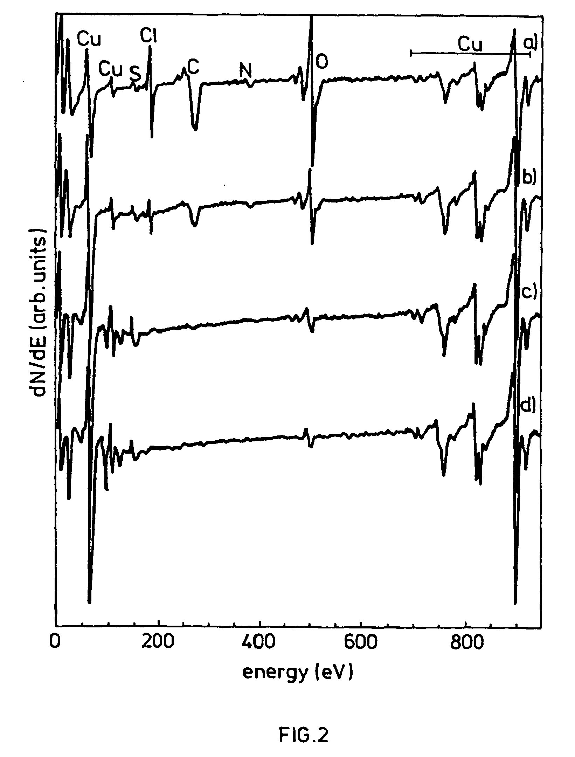

In Fig. 2 sind schliesslich die Auger-Spektren von Cu-Oberflächen ("lead frames") für die Erstellung einer Weichlotverbindung dargestellt.

Das Spektrum (a) wurde an einem nicht erfindungsgemäss behandelten "lead frame" aufgenommen.

Das Spektrum (b) wurde nach einer zweiminütigen erfindungsgemässen Vorbehandlung gemäss Fig. 4, Versuche I (d), aufgenommen, das Spektrum (c) nach einer vierminütigen derartigen Vorbehandlung, schliesslich das Spektrum (d) nach einer sechsminütigen derartigen Vorbehandlung. Dabei zeigt insbesondere die Entwicklung der C-Spitze bei 271 eV sowie der N-Spitze bei 379 eV und der O-Spitze bei 503 eV die Reinigungswirkung des erfindungsgemässen Verfahrens. Die Substrate, an welchen die Spektren gemäss Fig. 2 aufgenommen worden waren, wurden mit den angegebenen Behandlungszeiten in Argon/Stickstoff/Wasserstoff(4 %)-Plasmen behandelt. Bei Behandlung im Argon/Stickstoff-Plasma gemäss (d) von Fig. 4 bzw. 6 bleibt das Verhalten bezüglich C und N im wesentlichen gleich, hingegen wird Sauerstoff nicht vollständig reduziert.

Im einem Plasma mit Stickstoff behandelte und somit nachmals ohne weiteres luftlagerbare Werkstücke lassen sich, wie erwähnt wurde, an ihrer markanten Oberflächen-Stickstoff-Konzentration erkennen.

## Patentansprüche

1. Verfahren zur Herstellung von Bauteilen unter inniger Verbindung mindestens zweier Materialphasen, wovon mindestens die eine eine Festkörperphase ist und bei welchem Verfahren, vor der innigen Verbindung, mindestens die zu verbindende Oberfläche der Festkörperphase erst mittels plasmaaktiviertem Gas vorbehandelt, dann an Luft gelagert wird, **dadurch gekennzeichnet, dass** die Vorbehandlung mittels dem plasmaaktivierten Gas vorgenommen wird, welches überwiegend Stickstoff enthält.

2. Verfahren nach Anspruch 1, **dadurch gekennzeichnet, dass** die Vorbehandlung mittels eines plasmaaktivierten Gases, welches Wasserstoff enthält, vorgenommen wird.

3. Verfahren nach einem der Ansprüche 1 oder 2, **dadurch gekennzeichnet, dass** die Plasmaentladung als Niederspannungsentladung erzeugt wird, vorzugsweise ab einer thermionisch elektronenemittierenden Kathode.

4. Verfahren nach einem der Ansprüche 1 bis 3, **dadurch gekennzeichnet, dass** die Vorbehandlung mittels plasmaaktiviertem Gas vorgenommen wird, welches ein Arbeitsgas, vorzugsweise ein Edelgas, insbesondere bevorzugt Argon, enthält.

5. Verfahren nach einem der Ansprüche 1 bis 4, **dadurch gekennzeichnet, dass** die mindestens eine innig zu verbindende Festkörperoberfläche metallisch und/oder halbmetallisch und/oder keramisch ist und/oder aus Kunststoff besteht.

6. Verfahren nach einem der Ansprüche 1 bis 5, **dadurch gekennzeichnet, dass** man das innige Verbinden durch Kleben, Löten, Schweissen, Vergiessen oder Beschichten, insbesondere Vakuumbeschichten, oder durch Direkt-Bonden vornimmt.

7. Verfahren nach Anspruch 3, **dadurch gekennzeichnet, dass** man die Niederspannungsentladung mit einer Entladespannung ≤ 30 V und vorzugsweise mit einem Entladestrom zwischen 10 A und 300 A (beide Grenzen einschliessend) betreibt.

8. Verfahren nach einem der Ansprüche 1 bis 7, **dadurch gekennzeichnet, dass** das innige Verbinden durch Ultraschallschweissen realisiert wird.

**9.** Verfahren nach einem der Ansprüche 1 bis 8, **dadurch gekennzeichnet, dass** man mindestens die eine Festkörperphase während der Vorbehandlung in einer Halteanordnung lagert, welche bezüglich des Plasmaentladungsraumes verengte Durchgriffsbereiche auf die Oberfläche der Festkörperphase definiert.

**10.** Verfahren nach Anspruch 9, **dadurch gekennzeichnet, dass** die mindestens eine Festkörperphase durch ein scheiben- oder plattenförmiges Substrat gebildet ist und die Halteanordnung mindestens einen Durchgriffschlitz hierfür aufweist.

**11.** Verfahren nach Anspruch 10, **dadurch gekennzeichnet, dass** als Halteanordnung ein Magazin (12) mit mehreren Durchgriffschlitzen eingesetzt wird.

**12.** Verfahren nach einem der Ansprüche 1 bis 11, **dadurch gekennzeichnet, dass** die innige Verbindung gar an Luft erstellt wird, vorzugsweise bei einer Festkörpertemperatur von höchstens 150°C..

**13.** Verwendung des Verfahrens nach einem der Ansprüche 1 bis 12 für das Verbinden integrierter Schaltkreise mit einem HLST oder für das elektrische Kontaktieren integrierter Schaltkreise durch wire bonding oder für das Umhüllen von mit den HLST verbundenen, durch wire bonding kontaktierten elektrischen Schaltkreisen mit einer Gussmasse.

**14.** Verwendung des Verfahrens nach einem der Ansprüche 1 bis 9 für Flip-Chip-zu-verbindende und zu positionierende integrierte Schaltkreise sowie HLST, durch Aufschmelzen von Lötpunkten von Schaltkreis und HLST.

**15.** Verwendung des Verfahrens nach einem der Ansprüche 1 bis 11 für Werkstücke mit an schlecht zugänglichen Oberflächenbereichen, insbesondere Kanten, Durchbohrungen, Sackbohrungen, Spalten, Nuten, innig zu verbindenden Oberflächen.

**16.** Verwendung des Verfahrens nach einem der Ansprüche 1 bis 11 für Chips mit Cu-Leiterbahnen.

**Claims**

**1.** Method for production of components with intimate joining of at least two material phases, of which at least one is a solid body phase, and in which method, before the intimate joining, at least the solid body phase surface to be joined is firstly pre-treated by means of plasma-activated gas, and then stored in air, **characterised in that** the pre-treatment takes place by means of the plasma-activated gas which contains mainly nitrogen.

**2.** Method according to claim 1, **characterised in that** the pre-treatment takes place by means of a plasma-activated gas, which contains hydrogen.

**3.** Method according to one of claims 1 or 2, **characterised in that** the plasma discharge is generated as a low voltage discharge, preferably from a thermionically electron-emitting cathode.

**4.** Method according to any of claims 1 to 3, **characterised in that** the pre-treatment is carried out by means of plasma-activated gas, which contains a working gas, preferably an inert gas, in particular preferably argon.

**5.** Method according to any of claims 1 to 4, **characterised in that** the at least one solid body surface to be intimately joined is metallic and/or semi-metallic and/or ceramic and/or consists of synthetic material.

**6.** Method according to any of claims 1 to 5, **characterised in that** the intimate joining takes place by gluing, soldering, welding, casting or coating, in particular vacuum coating, or by direct bonding.

**7.** Method according to claim 3, **characterised in that** the low voltage discharge is operated with a discharge voltage of ≤ 30V and preferably with a discharge current between 10 A and 300 A (both limits included).

**8.** Method according to any of claims 1 to 7, **characterised in that** the intimate joining takes place by ultrasonic welding.

**9.** Method according to any of claims 1 to 8, **characterised in that** at least the one solid body phase is mounted during the pre-treatment in a holding arrangement, which defines, in relation to the plasma discharge chamber, areas of constricted access onto the surface of the solid body phase.

**10.** Method according to claim 9, **characterised in that** the at least one solid body phase is formed by a disc- or plate-like shaped substrate and the holding arrangement has at least one passage slot for this.

**11.** Method according to claim 10, **characterised in that** as a holding arrangement a magazine (12) with several passage slots is used.

**12.** Method according to any of claims 1 to 11, **characterised in that** the intimate joint is produced in air, preferably at a temperature of the solid body of at most 150°C.

**13.** Use of the method according to any of claims 1 to 12 for connecting integrated circuits with an HLST or for the electrical contacting of integrated circuits by wire bonding or for the embedding with a casting compound of electrical circuits that are connected with the HLST and contacted by wire bonding.

**14.** Use of the method according to any of claims 1 to 9 for integrated circuits to be positioned and flip-chip joined and HLST, by melting of solder points on the intimately circuit and HLST.

**15.** Use of the method according to any of claims 1 to 11 for workpieces with surfaces to be joined intimately at surface areas with difficult access, in particular edges, bores, blind bores, gaps, grooves.

**16.** Use of the method according to any of claims 1 to 11 for chips with Cu tracks.

**Revendications**

**1.** Procédé pour fabriquer des composants en reliant intimement au moins deux phases de matière, l'une au moins étant une phase de corps solide, selon lequel procédé, avant la liaison intime, au moins la surface à relier de la phase de corps solide est tout d'abord traitée préalablement à l'aide d'un gaz activé par plasma, puis exposée à l'air, **caractérisé en ce que** le traitement préalable est prévu à l'aide du gaz activé par plasma, qui contient principalement de l'azote.

**2.** Procédé selon la revendication 1, **caractérisé en ce que** le traitement préalable est réalisé à l'aide d'un gaz activé par plasma qui contient de l'hydrogène.

**3.** Procédé selon la revendication 1 ou 2, **caractérisé en ce que** la décharge de plasma est produite sous la forme d'une décharge basse tension, de préférence à partir d'une cathode émettant des électrons par voie thermo-ionique.

**4.** Procédé selon l'une des revendications 1 à 3, **caractérisé en ce que** le traitement préalable est réalisé à l'aide d'un gaz activé par plasma qui contient un gaz de travail, de préférence un gaz rare, en particulier préférablement de l'argon.

**5.** Procédé selon l'une des revendications 1 à 4, **caractérisé en ce que** la ou les surfaces de corps solide à relier intimement sont métalliques et/ou semi-métalliques et/ou céramiques et/ou sont en matière artificielle.

**6.** Procédé selon l'une des revendications 1 à 5, **caractérisé en ce qu'**on réalise la liaison intime par collage, brasage, soudage, scellage ou revêtement, en particulier par revêtement sous vide, ou grâce à une liaison directe.

**7.** Procédé selon la revendication 3, **caractérisé en ce qu'**on fait fonctionner la décharge basse tension avec une tension de décharge ≤ 30 V et de préférence avec un courant de décharge situé entre 10 A et 300 A (les deux limits inclus).

**8.** Procédé selon l'une des revendications 1 à 7, **caractérisé en ce que** la liaison intime est réalisée par soudage par ultrasons.

**9.** Procédé selon l'une des revendications 1 à 8, **caractérisé en ce que** l'on conserve au moins l'une des phases de corps solide, pendant le traitement préalable, dans un dispositif de fixation qui définit, par rapport à l'espace de décharge de plasma, des zones d'accès rétrécies à la surface de la phase de corps solide.

**10.** Procédé selon la revendication 9, **caractérisé en ce que** la ou les phases de corps solide sont formées par un substrat en forme de disque ou de plaque et le dispositif de fixation présente au moins une fente d'accès pour celui-ci.

11. Procédé selon la revendication 10, **caractérisé en ce qu'**on utilise comme dispositif de fixation un magasin (12) avec plusieurs fentes d'accès.

12. Procédé selon l'une des revendications 1 à 11, **caractérisé en ce que** la liaison intime est réalisée complètement à l'air, de préférence à une température de corps solide de 150°C aux maximum.

13. Utilisation du procédé selon l'une des revendications 1 à 12 pour relier des circuits intégrés à un HLST ou pour la connexion sur plaquette par fil de circuits intégrés ou pour enrober d'une masse de scellement des circuits électriques connectés sur plaquette par fil et reliés audit support.

14. Utilisation du procédé selon l'une des revendications 1 à 9, pour des circuits intégrés à relier à une puce à bosses et à positionner et HLST, par fusion de points de brasage du circuit et HLST.

15. Utilisation du procédé selon l'une des revendications 1 à 11 pour des pièces avec des surfaces à relier intimement au niveau de zones superficielles difficilement accessibles, en particulier des bords, des trous traversants, des trous borgnes, des fentes, des rainures,.

16. Utilisation du procédé selon l'une des revendications 1 à 11 pour des puces avec des pistes conductrices Cu.

**FIG.1**

FIG.2

$F_P$

38

53   57a

FIG.3

10 $F_P$ [cN]

9

8

7   Versuche I

6

5   SOLL ──────────────────────────

4

3

2

1

0

(a)          (b)          (c)          (d)
Ar/H$_2$     Ar       Ar/H$_2$/N$_2$   Ar/N$_2$

FIG.4

FIG.5

FIG.6

FIG.7